(19) Europäisches Patentamt
European Patent Office
Office européen des brevets

(11) EP 2 403 144 A1

(12) EUROPEAN PATENT APPLICATION

(43) Date of publication:
04.01.2012 Bulletin 2012/01

(51) Int Cl.:
$H03M \ 1/10^{(2006.01)}$   $H03M \ 1/80^{(2006.01)}$
$H03M \ 1/46^{(2006.01)}$

(21) Application number: 10168008.0

(22) Date of filing: 30.06.2010

(84) Designated Contracting States:
AL AT BE BG CH CY CZ DE DK EE ES FI FR GB
GR HR HU IE IS IT LI LT LU LV MC MK MT NL NO
PL PT RO SE SI SK SM TR
Designated Extension States:
BA ME RS

(71) Applicant: University of Limerick
Limerick (IE)

(72) Inventor: Scanlan, Anthony Gerard
Co. Limerick (IE)

(74) Representative: Lucey, Michael
PURDYLUCEY
Intellectual Property
Suite 138-139
The Chapel Building
Mary's Abbey
Dublin 7 (IE)

(54) **Digital background calibration system and method for successive approximation (SAR) analogue to digital converter**

(57)   The invention provides a digital background calibration system and method for a successive approximation analog-to-digital converter comprising a digital to analog converter (DAC) having a plurality of weighted capacitors to be calibrated; means for splitting each of said weighted capacitors into a plurality of sub-capacitors and at least one redundant capacitor; means for multiplying at least one of the sub-capacitors with a PN sequence; and means for calibrating the weighted capacitor from the multiplied sub-capacitor and the redundant capacitor.

Figure 9

EP 2 403 144 A1

**Description**

**Field of the Invention**

The invention relates to a digital background calibration scheme for an Analog to Digital converter (ADC). In particular the invention relates to a calibration system and method specifically to enable high resolution SAR conversion on nanometre process technologies.

**Background to the Invention**

Analog-to-Digital conversion remains an essential function for the latest systems on a chip designed in nanometre process technologies. The performance of analog circuits is difficult to maintain with reduced supply voltage and increased device mismatch. Furthermore system designers wish to achieve low power consumption and small area designs that can be readily scaled between technologies. The successive approximation (SAR) ADC is suitable for implementation in nanometre process technologies as it does not contain circuit elements that may not be fabricated in digital process technologies and is readily scalable. In order to achieve small area, low power consumption and small capacitive load, capacitors must be sized as small as possible. The lower limit of capacitor size is set by thermal noise considerations, but mismatch between capacitors will limit achievable resolution before the thermal noise limit is reached. In order to allow use of very small capacitors, calibration must be introduced into the ADC.

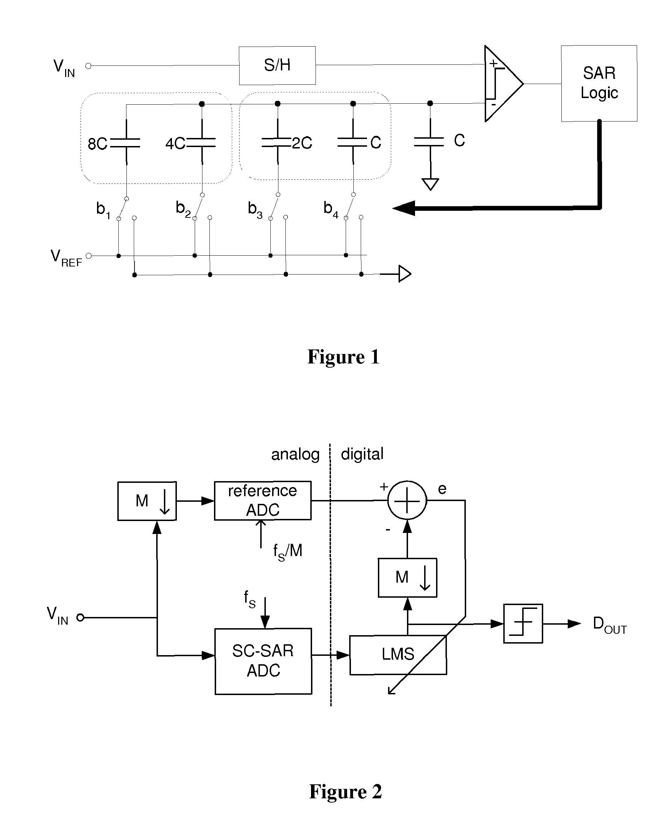

The principle of operation of this type of ADC is shown for a simple 4bit capacitor based ADC in Figure 1. The SAR converter comprises of the input sample and hold, a comparator, logic block and a digital to analog converter which in this case is capacitor based. Initially the input voltage to be converted $V_{IN}$, is sampled and held. The SAR logic connects the largest capacitor 8C to the reference voltage which changes the voltage at the negative terminal of the comparator by an amount directly proportional to the comparator size. This voltage is then compared against the held input voltage using the comparator. This result comprises the first MSB of the output digital word. Depending on the comparator decision the largest capacitor also is turned off (0) or remains on (1). The next largest capacitor 4C is then turned on and another comparison performed. In this manner the value of the $V_{IN}$ is approached iteratively at the negative terminal of the comparator and a digital word representing $V_{IN}$ is produced iteratively also.

The maximum achievable resolution of the SAR converter is dependent on the number of bits in the digital to analog converter. The practical limitation on the SAR resolution is dependent on the DAC i.e. the matching of the elements comprising the DAC. The purpose of the calibration schemes described in the prior art is to correct the elements of the DAC to improve the ADC resolution. There are numerous methods described in the art for calibrating SAR ADCs.

For example in a paper published by Liu, W.; Chiu, Y.; Background digital calibration of successive approximation ADC with adaptive equalisation Electronics Letters, Volume: 45, Issue: 9, 2009 , Page(s): 456 - 458 a background Digital Calibration with adaptive equalisation is described. In this approach, as shown in Figure 2 a slow-speed high-resolution reference ADC is placed in parallel with the SAR ADC that is to be calibrated. The reference ADC operates a factor M slower than the SAR ADC. The output of this ADC is therefore a very linear representation of the low frequency component of the input signal. The output of the SAR ADC is applied to a LMS adaptive filter. The output of this filter is controlled by the error between the decimated output of this filter and the output of the reference ADC. The effect of this feedback loop is to force the decimated output of the LMS filter to be equal to the reference ADC. Since the reference ADC output is linear the output of the LMS is also forced to be linear thereby producing a calibration. The problem with this approach is the requirement of a linear reference ADC and a large digital overhead.

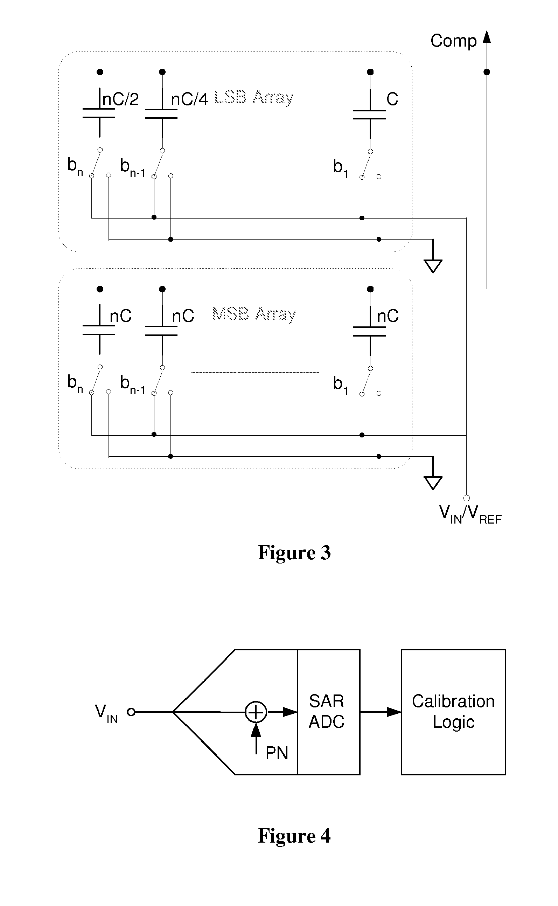

In a paper published by He Yong; Wu Wuchen; Meng Hao; Zhou Zhonghua; A 14-bit successive-approximation AD converter with digital calibration algorithm ASIC, 2009. ASICON '09. IEEE 8th International Conference on 2009, Page(s): 234 - 237 a digital foreground calibration scheme is disclosed, as shown in Figure 3. In this method the SAR algorithm itself is efficiently used for self-calibration. The capacitors representing the LSBs have a higher matching tolerance than the MSBs and may be sufficiently accurate to measure the relative error of the capacitors representing the MSBs. This approach stores the measured relative errors in a ROM and additional capacitors may be switched on in parallel with the MSBs in normal operating mode to provide a calibration. The disadvantage of this method is that it operates in foreground and required additional capacitors to effect calibration.

Another method is to use a Perturbation and Equalisation Approach, for example as disclosed in Wenbo Liu; Pingli Huang; Yun Chiu; A 12b 22.5/45MS/s 3.0mW 0.059mm2 CMOS SAR ADC achieving over 90dB SFDR. Solid-State Circuits Conference Digest of Technical Papers (ISSCC), 2010 IEEE International, Page(s): 380 - 381. In this approach a pseudo-random (PN) perturbation is applied in series with the input signal, as shown in Figure 4. The addition or subtraction of the perturbation is controlled by a pseudo-random sequence. A second sample is obtained with the perturbation reversed. This creates two input samples which utilise different paths through the ADC. Similar to the techniques used above an equalisation method is used to force the error between the paths to zero. This has again the effect of calibrating the ADC. This approach saves on area by using paths rather than a separate ADC. Disadvantages include the need to sample the input signal twice thus halving speed and secondly the reduction on input range of adding the PN signal.

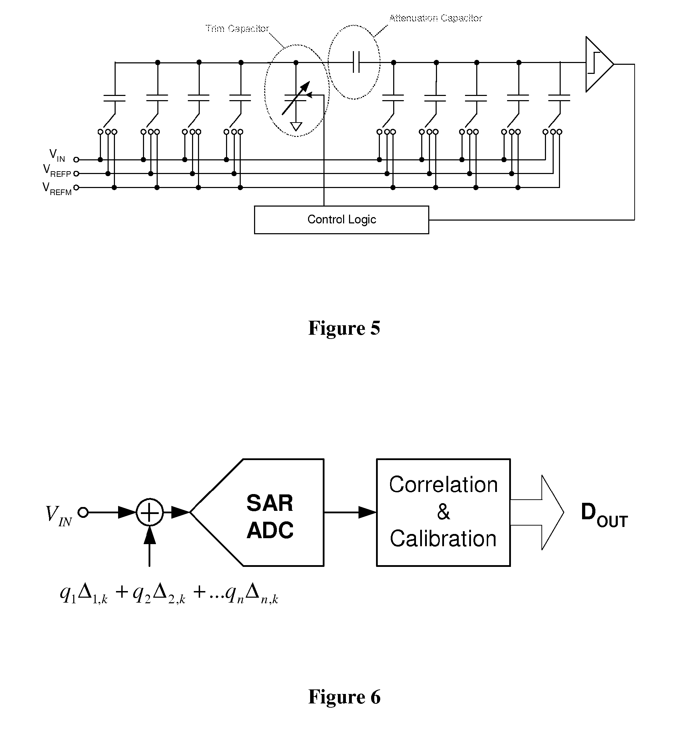

Another method uses a calibration for gain error in split array, as disclosed in a paper by Yanfei Chen; Xiaolei Zhu; Tamura, H.; Kibune, M.; Tomita, Y.; Hamada, T.; Yoshioka, M.; Ishikawa, K.; Takayama, T.; Ogawa, J.; Tsukamoto, S.; Kuroda, T.; Split capacitor DAC mismatch calibration in successive approximation ADC. Custom Integrated Circuits Conference, 2009. CICC '09. IEEE Publication Year: 2009 , Page(s): 279 - 282. In the case where attenuation capacitors are utilised to reduce the overall input capacitance of the SAR ADC, gain errors are introduced between the portions of the array on either side of the attenuation capacitor. These gain errors arise due to systematic and random sizing errors of the attenuation capacitor and also due to parasitic capacitance. In order to calibrate this error an additional capacitor is added to the array and it may be trimmed in order to adjust the effective gain of the attenuation capacitor to eliminate errors. This process is performed in the foreground. Figure 5 details the capacitor array, showing the attenuation capacitor and a trim capacitor.

Problems with Calibrated SAR ADC converters include addition of extra analog hardware, inability to compensate for gain error, addition of high speed logic and large power overhead.

There is therefore a need to provide a calibration system and method specifically to enable high resolution SAR conversion on nanometre process technologies to overcome the above mentioned problems.

### Summary of the Invention

According to the invention there is provided, as set out in the appended claims, a digital background calibration system for a successive approximation analog-to-digital converter comprising:

a digital to analog converter (DAC) comprising a plurality of weighted capacitors to be calibrated;
means for splitting each of said weighted capacitors into a plurality of sub-capacitors and at least one redundant capacitor;
means for multiplying at least one of the sub-capacitors with a PN sequence; and means for calibrating the weighted capacitor from the multiplied sub-capacitor and the redundant capacitor.

The invention presents a digital background calibration scheme for a successive approximation analog-to-digital converter ADC. Calibration schemes may be classified by their method of operation. If conversion is interrupted or calibration takes place during manufacture the calibration is considered to be a foreground scheme. If conversion can take place simultaneously with calibration it is considered to be a background calibration scheme. If calibration involves adjustment of analog elements of the converter such as trimming a capacitor the scheme is referred to as an analog calibration scheme. If the calibration scheme involves adjusting the output digital codes it is referred to as a digital calibration scheme. The system and method of the invention can be easily implemented in digital nanometre technology and is scalable between technologies, and provides the following advantages:

● Calibration scheme is primarily digital, only small amount of analog hardware required.
● Can compensate for gain error introduced by attenuation capacitors to reduce total input capacitive load and can perform this function digitally.
● Allows high speed operation as doesn't require additional logic on high speed path.
● Small Area/Power Overhead.
● Does not require two input samples thus preserving fast operating speed.

In one embodiment said means for calibrating produces output codes adapted to compensate for errors of the weighted capacitors.

In one embodiment the DAC comprises input from a PN generator circuit and a sub-capacitor selection circuit.

In one embodiment the PN generator module and the sub-capacitor selection module operate at a lower speed than the DAC.

In one embodiment at the start of each conversion cycle one of the sub-capacitors $\Delta_{i,k}$ is randomly selected from a signal obtained from the sub-capacitor selection circuit to be multiplied by a the current value of the pseudo random sequence $q_{i,x}$ supplied from the PN generator circuit.

In one embodiment a voltage directly proportional to at least one weighted capacitor is added to an input voltage $V_{IN}$, and adapted to be converted to a digital value represented by $D(V_{IN} + q_{i,x} \cdot \Delta_{i,k})$.

In one embodiment the converted value is multiplied by the $q_{i,x}$ value to perform a correlation, and the output is adapted to be accumulated and averaged to obtain a DC value, represented by $D(\overline{\Delta}_i)$.

In one embodiment there is provided means for subtracting the DC value from the expected value for the sub-capacitor $D(\Delta \exp_i)$ to provide an error value $\overline{\varepsilon}_i$ ; and means for multiplying by the plurality of sub-capacitors to obtain the value used for calibration.

In one embodiment there is provided means for subtracting $D(\overline{\Delta_i}) \cdot q_{i,x}$ from the converted signal $D(V_{IN} + q_{i,x} \cdot \Delta_{i,k})$ to remove a pertubation signal from the output signal allowing conversion to occur during calibration.

In one embodiment the DAC comprises at least one attenuation capacitor adapted to provide low values of capacitance during operation.

In one embodiment there is provided a trim capacitor adapted to compensate for gain error introduced by attenuation capacitor. Ideally the measured gain error determines the value of the trim capacitor and applied on the right hand side of the trim capacitor to adjust the gain error.

In one embodiment the system comprises means for increasing the capacitor size such that any perturbations can be allowed to occupy this additional range, with $2^N$-1 codes available for the input signal as required.

In one embodiment the system comprises means for forcing the calibration of each weighted capacitor to occur sequentially, or in a sequence of parallel combinations, such that the input range available for the signal is increased.

In one embodiment the system comprises means for increasing the number of segments each weighted capacitor is split up into such that the size of the perturbation signal is reduced.

In another embodiment of the present invention there is provided a method of digital background calibrating a successive approximation analog-to-digital converter comprising:

arranging a digital to analog converter (DAC) having a plurality of weighted capacitors to be calibrated;
splitting each of said weighted capacitors into a plurality of sub-capacitors and at least one redundant capacitor;
multiplying at least one of the sub-capacitors with a PN sequence; and calibrating the weighted capacitor from the multiplied sub-capacitor and the redundant capacitor.

In one embodiment there is provided the step of calibrating produces output codes adapted to compensate for errors of the weighted capacitors.

There is also provided a computer program comprising program instructions for causing a computer program to carry out the above method which may be embodied on a record medium, carrier signal or read-only memory.

## Brief Description of the Drawings

The invention will be more clearly understood from the following description of an embodiment thereof, given by way of example only, with reference to the accompanying drawings, in which:-

Figure 1 illustrates principle of operation of a SAR ADC is shown for a simple 4bit capacitor based;
Figure 2 illustrates a prior art digital calibration scheme;
Figure 3 illustrates a prior art array for Digital Foreground Calibration;
Figure 4 illustrates a prior art Perturbation and Equalisation approach;
Figure 5 illustrates a prior art method of calibration of gain error due to attenuation capacitor;
Figure 6 illustrates SAR ADC with Calibration Scheme;
Figure 7 illustrates an implementation of (a) PN injection and Measurement by Correlation (b) with error;
Figure 8 illustrates operation of the calibration Scheme according to one aspect of the invention;
Figure 9 illustrates a block diagram of the ADC with Calibration Scheme according to the invention;
Figure 10 illustrates SAR ADC High Speed Circuitry: DAC Array (redundant capacitors not shown), Comparator and SAR Algorithm Logic;
Figure 11 illustrates a detailed implementation of correlation based calibration scheme according to the invention;
Figure 12 illustrates a flow chart for the calibration scheme according to another aspect of the invention;
Figure 13 illustrates use of a trim capacitor to calibrate attenuation capacitor according to another aspect of the invention; and
Figures 14 to 16 illustrate results obtained to confirm operation of the invention.

## Detailed Description of the Drawings

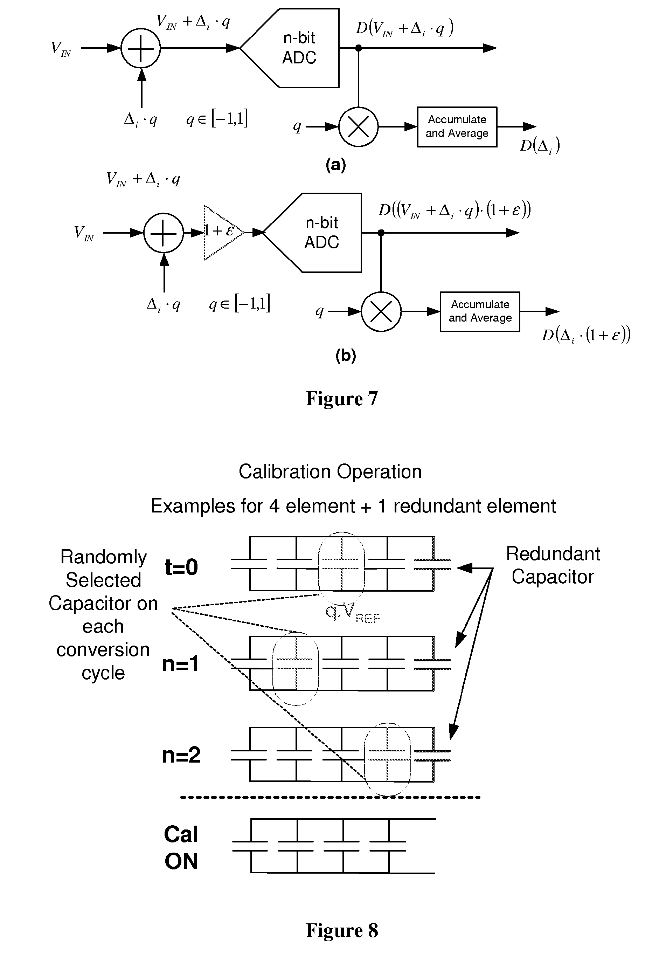

Figure 6 illustrates a typical SAR ADC comprising of a DAC consisting of n relative weighted capacitors (or other elements in other embodiments) for example [64, 32, 16, 8, 4, 2, 1]. Due to mismatch the relative weights of these capacitors varies e.g. weights now are [63.2, 31.7, 15.8, 7.5, 3.8, 2.1, 1.3]. For calibration too take place the magnitude, and hence errors, of each capacitor has to be determined and compensated in the digital domain. To measure one of the capacitors it must be modulated by a PN sequence, the resulting voltage converted by the ADC, the digital values correlated with a PN sequence and finally the DC value determined (as shown in figure 7a and 7b). However this would yield a foreground calibration scheme.

The principle of using a PN sequence to measure an analog quantity is shown in figure 7a. An additional voltage or element $\Delta_i$ (causing a voltage change) is multiplied by the pseudo random sequence q and is added to the input signal. This combined signal is processed by the ADC, converting it to a digital value. Multiplication of the digital value by the pseudo random sequence performs a correlation operation, the correlation value may be low pass filtered by an ideal integrator. This can be achieved by performing an accumulation and average operation. The output of the operation is a measure of the added element $D(\Delta_i)$. Note the input signal is removed as it is not correlated with the pseudo random sequence. This methodology can be used for calibration in pipeline ADCs. Each stage of the pipeline may be calibrated using the following stages as an n-bit ADC. As shown in Figure 7b a gain error may be detected by the same method, the gain error is multiplied by the known value added to the input signal. The value of $\varepsilon$ may be extracted and be calibrated for.

Figure 8 illustrates operation of the calibration scheme according to the invention. In order to achieve a background calibration scheme each capacitor to be calibrated must be broken into m sub-capacitors in a DAC. As shown in Figure 8 one of the sub-capacitors is chosen at random to be multiplied by a PN sequence generated. A redundant capacitor is used to approximately make-up the loss in the capacitor to be calibrated when it used for conversion. By using each of the sub-elements in turn the value determined by correlation is equal to

$$D\left(\overline{\Delta_i}\right) = \frac{\Delta_{i,1} + \Delta_{i,2} + \ldots.\Delta_{i,m}}{m}.$$ . The error $\varepsilon_i$ m between the measured value and expected value $D(\Delta \exp_i)$ is then

added to the output codes exactly compensating for the error in the measured capacitor

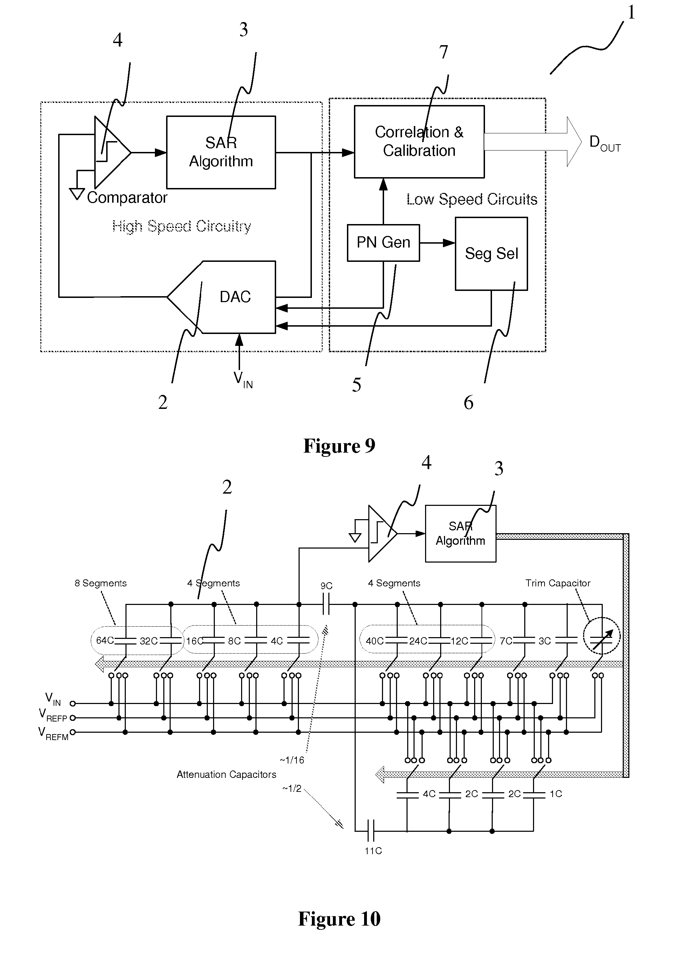

The top level block diagram of the SAR ADC with calibration according to a preferred embodiment of the invention is shown in Figure 9, indicated generally by the reference numeral 1. The SAR ADC circuit operates at n times the sample rate (n cycles to complete a single sample conversion) comprise of a DAC 2, a SAR Algorithm logic module 3 and a comparator 4. The SAR algorithm logic 3 and comparator 4 are not affected by the calibration operation. According to a first aspect of the invention the DAC 2 is modified to have capacitors split into segments and redundant capacitors are added as shown in Figure 8. It will be appreciated that this does not affect the speed of DAC operation which is desired to operate as quickly as possible. Additional digital circuits operate at the lower speed sample rate comprising of a PN generator 5 and a sub-capacitor selection circuit 6. The sub-capacitor selection circuit 6 is configured to operate randomly. Low speed circuits determine selection of which segment is to be PN modulated and the value of PN sequence. Correlation module 7 comprises means for performing operations, averaging and calculation of the calibration value occur at the lower sample rate also.

The detail of the high speed DAC circuitry is shown in Figure 10. A capacitor array is formed from three sections, with one or more attenuation capacitors between the sections. The use of attenuation capacitors allows low values of input capacitance to be achieved. The calibration scheme is compatible with capacitor arrays using/not-using attenuation. In the embodiment shown the DAC array is designed for 12 bits with an additional two capacitors to enable redundancy to compensate for settling errors at high speed, although it will be appreciated other designs are possible. The capacitors to be calibrated are highlighted (rectangles with two rounded sides), with the number of segments each capacitor is to be broken into for calibration purposes denoted.

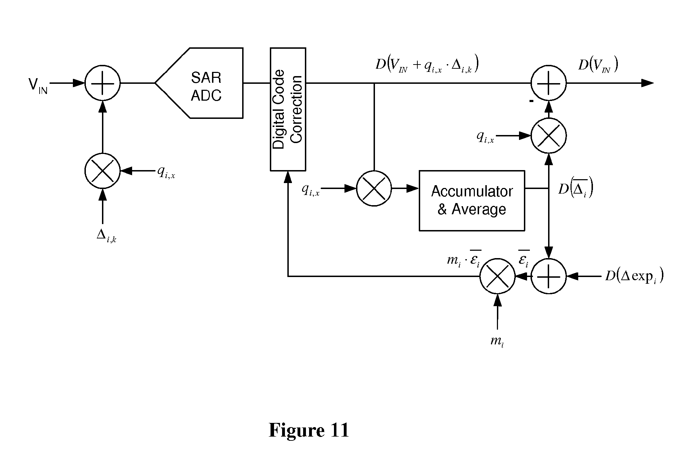

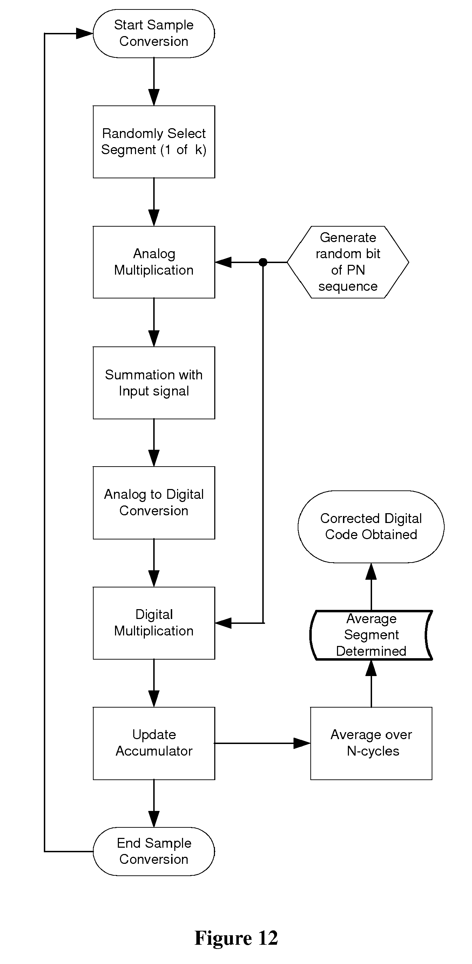

The detail of the complete calibration operation is shown Figure 11. The operation of the calibration scheme can work in the following manner. Consider the calibration of the ith capacitor. The capacitor consists of $m_i$ segments, at the start of the each conversion cycle one of the segments $\Delta_{i,k}$ is randomly selected to be multiplied by the current value of the pseudo random sequence $q_{i,x}$ which has the value either [-1,1]. Note that there is a separate sequence $q_i$ for each capacitor to be calibrated. A voltage directly proportional to the capacitor (can be assumed to be 1 for simplicity) is added to the input voltage, this is converted to a digital value $D(V_{IN} + q_{i,x} \Delta_{i,k})$ by the SAR ADC. The complete conversion takes place over n-cycles as for a typical SAR ADC. The converted value is multiplied by the $q_{i,x}$ value to perform a correlation, the output is accumulated and averaged (1st order filter) to obtain a DC value $D(\overline{\Delta_i})$. Over many conversions this value converges to a digital representation of the mean of each of the $\Delta_{i,k}$ capacitor segments. Subtracting this value from the expected value for the capacitor segment $D(\Delta \exp_i)$ leads to an error valuer $\overline{\varepsilon_i}$, this is multiplied by $m_i$ the number of segments to obtain the value used for correction $m_i \cdot \overline{\varepsilon_i}$. Note that the value of $D(\overline{\Delta_i})$ is subtracted from $D(V_{IN} + q_{i,x} \cdot \Delta_{i,k})$ to leave $D(V_{IN})$, this is necessary to remove the effect of adding the capacitor segments in calibration mode. Note that imperfect subtraction does occur and converter performance will be impaired while calibration is running. This is because the value of $D(\overline{\Delta_i})$ is not exactly equal to the $D(\Delta_{i,k})$ on each sample. When calibration is complete all $q_{i,x}$ are set to zero and this error is removed. Figure 12 illustrates a flow chart of the calibration scheme according to the invention.

In another embodiment of the invention the scheme can be extended for calibration of gain error due to the attenuation capacitor. Correction of the gain error due to attenuation capacitor requires extension of the calibration scheme. The gain error may be detected from the common gain applied to the measured value of capacitors on the RHS of the attenuation capacitor. This gain error may be used to select the value of a trim capacitor applied on the RHS which has the effect of adjusting the gain error.

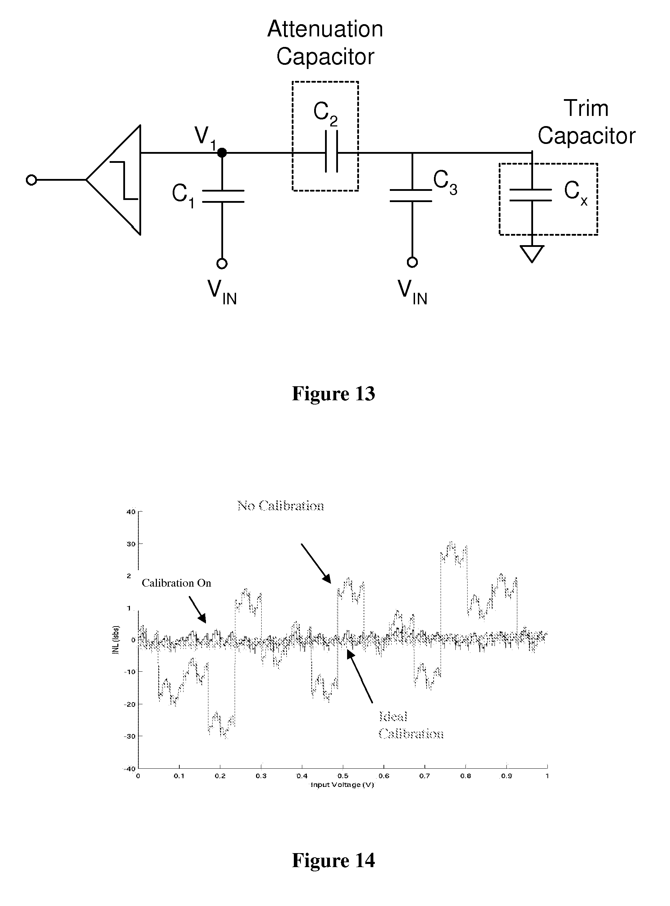

Figure 13 details the principle of gain correction utilising a trim capacitor. The attenuation of N between the LHS and RHS side of the array is given by:

$$N = \frac{C_1 + C_X}{C_2} + 1 \qquad (1)$$

if $C_x$ is set to zero $C_2 = C_1/N\text{-}1$. If however $C_2$ is fabricated with an error and has the value , the value of attenuation N achieved will now have a gain error $N(1 + \varepsilon)$. Therefore from equation 1, the gain with error is given as,

$$N(1 + \varepsilon) = \frac{C_1}{C_2^{'}} + 1 \qquad (2)$$

However by giving $C_x$ a non-zero value however the gain error can be removed,

$$N = \frac{C_1 + C_X}{C_2^{'}} + 1 \qquad (3)$$

from equations 2,3 the value of $C_x$ necessary to correct the gain error is given by,

$$C_X = \frac{-C_1 N \varepsilon}{[N(1 + \varepsilon) - 1]} \qquad (4)$$

In the above expression the value of $C_2$ is not present, thus its value does not need to be measured.

It is noted that for the value of $C_x$ in the above equation is negative, this will be positive if $\varepsilon$ is negative. Therefore in practice the nominal value of $C_2$ is designed to produce a negative gain error in N, so that it can be corrected by a positive (physically realisable) $C_x$.

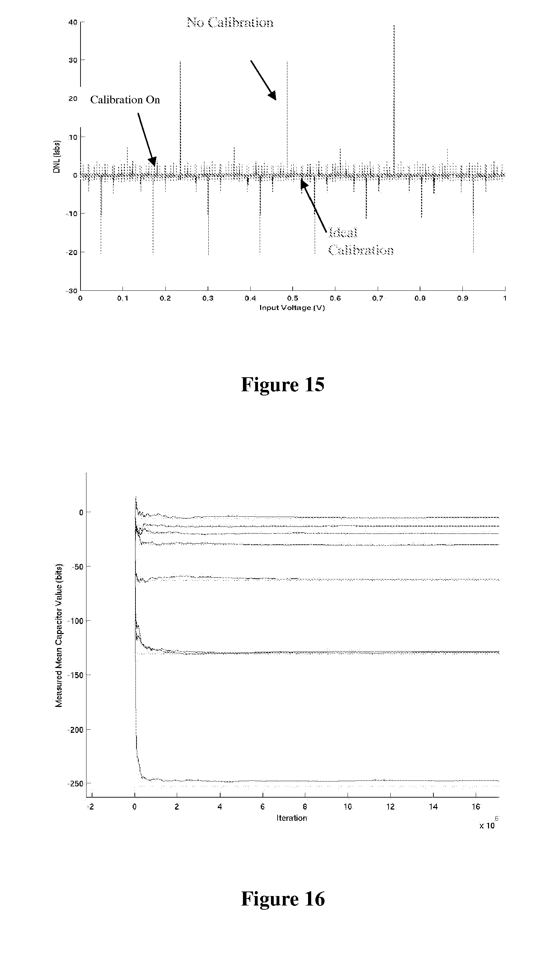

Figures 14 and 15 shows the INL and DNL outputs of a 12bit ADC with calibration on/off obtained from MATLAB simulations. Figure 16 details the convergence of the accumulated and averaged values of the capacitors $D(\overline{\Delta}_i)$ in section (i) above.

The embodiments in the invention described with reference to the drawings comprise a computer apparatus and/or processes performed in a computer apparatus. However, the invention also extends to computer programs, particularly computer programs stored on or in a carrier adapted to bring the invention into practice. The program may be in the form of source code, object code, or a code intermediate source and object code, such as in partially compiled form or in any other form suitable for use in the implementation of the method according to the invention. The carrier may comprise a storage medium such as ROM, e.g. CD ROM, or magnetic recording medium, e.g. a floppy disk or hard disk. The carrier may be an electrical or optical signal which may be transmitted via an electrical or an optical cable or by radio or other means.

In the specification the terms "comprise, comprises, comprised and comprising" or any variation thereof and the terms include, includes, included and including" or any variation thereof are considered to be totally interchangeable and they should all be afforded the widest possible interpretation and vice versa.

The invention is not limited to the embodiments hereinbefore described but may be varied in both construction and detail.

**Claims**

1.  A digital background calibration system for a successive approximation analog-to-digital converter comprising:

    a digital to analog converter (DAC) comprising a plurality of weighted capacitors to be calibrated;

means for splitting each of said weighted capacitors into a plurality of sub-capacitors and at least one redundant capacitor;
means for multiplying at least one of the sub-capacitors with a PN sequence; and
means for calibrating the weighted capacitor from the multiplied sub-capacitor and the redundant capacitor.

2. The digital background calibration system as claimed in claim 1 wherein said means for calibrating produces output codes adapted to compensate for errors of the weighted capacitors.

3. The digital background calibration system as claimed in any preceding claim wherein the DAC comprises input from a PN generator circuit and a sub-capacitor selection circuit.

4. The digital background calibration system as claimed in claim 3 wherein the PN generator module and the sub-capacitor selection module operate at a lower speed than the DAC.

5. The digital background calibration system as claimed in claims 3 or 4 wherein at the start of each conversion cycle one of the sub-capacitors $\Delta_{i,k}$ of the $i$th weighted capacitor is randomly selected from a signal obtained from the sub-capacitor selection circuit to be multiplied by a the current value of the pseudo random sequence $q_{i,x}$ supplied from the PN generator circuit.

6. The digital background calibration system as claimed in any preceding claim wherein a voltage directly proportional to at least one sub-capacitor is added to an input voltage, and adapted to be converted to a digital value represented by $D(V_{IN} + q_{i,x} \cdot \Delta_{i,k})$.

7. The digital background calibration system as claimed in claim 6 wherein the converted value is multiplied by the $q_{i,x}$ value to perform a correlation, and the output is adapted to be accumulated and averaged to obtain a DC value, represented by $D(\overline{\Delta_i})$.

8. The digital background calibration system as claimed in claim 7 comprising means for subtracting the DC value from the expected value for the sub-capacitor $D(\Delta \exp_i)$ to provide an error value $\overline{\varepsilon_i}$; and means for multiplying by the plurality of sub-capacitors to obtain the value used for calibration.

9. The digital background calibration system as claimed in claims 7 or 8 comprising means for subtracting $D(\overline{\Delta_i}) \cdot q_{i,x}$ from the converted signal $D(V_{IN} + q_{i,x} \cdot \Delta_{i,k})$ to remove a pertubation signal from the output signal allowing conversion to occur during calibration.

10. The digital background calibration system as claimed in any preceding claim wherein the DAC comprises at least one attenuation capacitor adapted to provide low values of capacitance during operation.

11. The digital background calibration system as claimed in any preceding claim comprising a trim capacitor adapted to compensate for gain error.

12. The digital background calibration system as claimed in claim 10 wherein the gain error determines the value of the trim capacitor and applied on the right hand side of the trim capacitor to adjust the gain error.

13. The digital background calibration system as claimed in any preceding claim comprising a redundant capacitor adapted to compensate for loss in signal level by a pertubation process using one of the sub-capacitors on any given sampling instant.

14. The digital background calibration system as claimed in any preceding claim comprising means for increasing input signal range with a small increase in capacitor sizesuch that any perturbations can be allowed to occupy this additional range, with $2^N$-1 codes available for the input signal as required and means for forcing the calibration of each weighted capacitor to occur sequentially, or in a sequence of parallel combinations such that input range available to the signal is increased or means for increasing the number of segments each weighted capacitor is split up into such that the size of the perturbation signal is reduced.

15. A method of digital background calibrating a successive approximation analog-to-digital converter comprising:

arranging a digital to analog converter (DAC) having a plurality of weighted capacitors to be calibrated;

splitting each of said weighted capacitors into a plurality of sub-capacitors and at least one redundant capacitor;
multiplying at least one of the sub-capacitors with a PN sequence; and
calibrating the weighted capacitor from the multiplied sub-capacitor and the redundant capacitor.

**Figure 1**

**Figure 2**

Comp

nC/2 | nC/4 LSB Array | C

$b_n$ | $b_{n-1}$ | $b_1$

nC | nC MSB Array | nC

$b_n$ | $b_{n-1}$ | $b_1$

$V_{IN}/V_{REF}$

**Figure 3**

$V_{IN}$

PN

SAR ADC

Calibration Logic

**Figure 4**

Trim Capacitor

Attenuation Capacitor

V<sub>IN</sub>
V<sub>REFP</sub>
V<sub>REFM</sub>

Control Logic

**Figure 5**

$V_{IN}$

$$q_1 \Delta_{1,k} + q_2 \Delta_{2,k} + ...q_n \Delta_{n,k}$$

**SAR ADC**

Correlation & Calibration

$\mathbf{D}_{\mathbf{OUT}}$

**Figure 6**

**Figure 7**

Calibration Operation

Examples for 4 element + 1 redundant element

**Figure 8**

EP 2 403 144 A1

Figure 9

Figure 10

13

**Figure 11**

**Figure 12**

Attenuation
Capacitor

Trim
Capacitor

**Figure 13**

**Figure 14**

**Figure 15**

**Figure 16**

Europäisches
Patentamt
European
Patent Office
Office européen
des brevets

## EUROPEAN SEARCH REPORT

Application Number

EP 10 16 8008

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | WENBO LIU ET AL: "A 12b 22.5/45MS/s 3.0mW 0.059mm2 CMOS SAR ADC achieving over 90dB SFDR", SOLID-STATE CIRCUITS CONFERENCE DIGEST OF TECHNICAL PAPERS (ISSCC), 2010 IEEE INTERNATIONAL, IEEE, PISCATAWAY, NJ, USA, 7 February 2010 (2010-02-07), pages 380-381, XP031649922, ISBN: 978-1-4244-6033-5 * page 380, left-hand column, lines 11-14; figures 21.2.1-21.2.2 * ----- | 1-15 | INV. H03M1/10 ADD. H03M1/80 H03M1/46 |

TECHNICAL FIELDS
SEARCHED       (IPC)

H03M

The present search report has been drawn up for all claims

| Place of search | Date of completion of the search | Examiner |
|---|---|---|
| The Hague | 20 December 2010 | Beindorff, Henk |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **LIU, W. ; CHIU, Y.** Background digital calibration of successive approximation ADC with adaptive equalisation. *Electronics Letters,* 2009, vol. 45 (9), 456-458
- **HE YONG ; WU WUCHEN ; MENG HAO ; ZHOU ZHONGHUA.** A 14-bit successive-approximation AD converter with digital calibration algorithm ASIC. *ASICON '09. IEEE 8th International Conference on 2009,* 2009, 234-237

- **WENBO LIU ; PINGLI HUANG ; YUN CHIU.** A 12b 22.5/45MS/s 3.0mW 0.059mm2 CMOS SAR ADC achieving over 90dB SFDR. Solid-State Circuits Conference Digest of Technical Papers (ISSCC. *IEEE International,* 2010, 380-381
- Split capacitor DAC mismatch calibration in successive approximation ADC. **YANFEI CHEN ; XIAOLEI ZHU ; TAMURA, H. ; KIBUNE, M. ; TOMITA, Y. ; HAMADA, T. ; YOSHIOKA, M. ; ISHIKAWA, K. ; TAKAYAMA, T. ; OGAWA, J.** Custom Integrated Circuits Conference, 2009. CICC '09. IEEE Publication, 2009, 279-282